# EUROPÄISCHE PATENTSCHRIFT

(11) **EP 3 309 811 B1**
(45) Veröffentlichungstag und Bekanntmachung des Hinweises auf die Patenterteilung: **19.12.2018**
(21) Anmeldenummer: 16193289.2
(22) Anmeldetag: 11.10.2016
(51) Int. Cl.: H01H 47/00, H01H 47/32, H02H 3/24

(54) **SCHÜTZ MIT EINER ELEKTRONISCHEN SPULENANSTEUERUNG**
CONTACTOR WITH ELECTRONIC COIL CONTROL
PROTECTION COMPRENANT UNE COMMANDE DE BOBINE ÉLECTRONIQUE

(43) Veröffentlichungstag der Anmeldung: 18.04.2018
(73) Patentinhaber: Siemens Aktiengesellschaft, 80333 München (DE)
(72) Erfinder: Oppermann, Christian, 92224 Amberg (DE); Streich, Bernhard, 92224 Amberg (DE)

(56) Entgegenhaltungen:
- EP-A2- 0 387 729
- EP-A2- 1 100 103
- DE-U1- 29 909 904

## Beschreibung

Die Erfindung betrifft einen Schütz mit einer elektronischen Spulenansteuerung für eine Magnetspule, wobei das Konstanthalten der Anzugsleistung der Magnetspule durch eine Stromtaktung ausgebildet ist, und mit einer sicherheitsgerichteten Ausgangsbaugruppe einer speicherprogrammierbaren Steuerung für die Fehlerdiagnose des Schütz, wobei die sicherheitsgerichtete Ausgangsbaugruppe den Stromfluss, der in den Schütz fließt, ermittelt und bei Unterschreiten eines Grenzwertes einen Fehler erkennt und abschaltet.

Ein Schütz arbeitet üblicherweise nach dem Prinzip eines Elektromagneten. Ein Strom in der Erregerspule erzeugt einen magnetischen Fluss durch einen ferromagnetischen Kern und einen beweglich gelagerten ferromagnetischen Anker. An einem Luftspalt kommt es zur Krafteinwirkung auf den Anker, wodurch dieser einen oder mehrere Kontakte des Schaltelements schaltet. Üblicherweise wird der Anker durch Federkraft in die Ausgangslage zurückversetzt, sobald die Spule nicht mehr erregt ist. Das Öffnen oder das Schließen des Schaltelements wird über die Erregung der Spule gesteuert. Durch das Erregen der Spule wird ein mit dem Anker verbundener beweglich gelagerter Kontakt mit einem Festkontakt des Schaltelements elektrisch leitend verbunden oder von dem Festkontakt elektrisch getrennt. Im geschlossenen Zustand des Schaltelements wird die über das Schaltelement geführte Energieversorgung des Stromkreises aufrecht erhalten. Im geöffneten Zustand wird die über das Schaltelement geführte Energieversorgung des Stromkreises unterbrochen.

Schütze werden immer mehr mittels einer speicherprogrammierbaren Steuerung (SPS) angesteuert. Die Ausgänge dieser SPS bestehen zunehmend aus Halbleitern mit einer maximalen Strombelastung von 0,5 oder 2A bei 24V und einem DC-Strom. Auf Grund von Energie- und Ressourceneinsparungen werden Schütze immer mehr mit integrierten elektronischen Spulenansteuerungen ausgestattet. Diese haben eine sehr hohe kurzzeitige Anzugsleistung, die allerdings im Vergleich zu konventionellen Geräten konstant ist. Die Energieeinsparung findet in der Halteperiode statt. Das Konstanthalten der Anzugsleistung wird erreicht, indem der Strom durch die Magnetspule getaktet wird.

Sicherheitsgerichtete Ausgangsbaugruppen von speicherprogrammierbaren Steuerungen haben verschiedene Diagnosemöglichkeiten, unter Anderem eine Kurzschlusserkennung oder die Möglichkeit, die Unterbrechungen der Leitungen zum Schütz hin zu diagnostizieren. Für die Leitungsunterbrechungen liest die Ausgangsbaugruppe den Strom zurück, der in das angeschlossene Gerät fließt. Ist er unterhalb eines Grenzwertes, erkennt die Ausgangsbaugruppe einen Fehler und schaltet ab. Da die Anzugsleistung des Schütz aber durch eine Elektronik mit sehr geringer Stromaufnahme getaktet wird, kann es vorkommen, dass das Rücklesen des Stroms entweder in die Hochlaufphase des angeschlossenen Geräts fällt oder in eine Pause des Taktes. Dadurch wird eine Leitungsunterbrechung erkannt, obwohl die Leitung in Ordnung ist.

Im Stand der Technik gab es bisher klassische DC-Antriebe ohne elektronische Spulenansteuerung. Diese werden kontinuierlich vom Strom durchflossen, so dass Fehlermeldungen ausgeschlossen waren.

Als Alternative für elektronisch gesteuerte Antriebe werden außerdem Widerstände verwendet, die parallel zum Gerät angeklemmt werden. Der Nachteil hierbei ist, dass der Strom ständig durch diese Widerstände fließt, so dass es also zum Einen zu einer Erwärmung kommt und zum Anderen zu einer unnützen Verlustleistung.

Die EP 0 387 729 A2 beschreibt ein Schütz mit einer elektronischen Spulenansteuerung für eine Magnetspule, wobei das Konstanthalten der Anzugsleistung der Magnetspule durch eine Stromtaktung ausgebildet ist, und mit einer sicherheitsgerichteten Ausgangsbaugruppe einer speicherprogrammierbaren Steuerung für die Fehlerdiagnose des Schütz, wobei die sicherheitsgerichtete Ausgangsbaugruppe den Stromfluss, der in den Schütz fließt, ermittelt und bei Unterschreiten eines Grenzwertes einen Fehler erkennt und abschaltet.

Demgemäß besteht die Aufgabe der vorliegenden Erfindung darin, einen Schütz mit einer energieeffizienten elektronischen Spulenansteuerung unter Verwendung eines sicherheitsgerichteten speicherprogrammierbaren Steuerungsausgangs zu schaffen.
Diese Aufgabe wird erfindungsgemäß durch einen Schütz mit den Merkmalen des Patentanspruchs 1 gelöst. Vorteilhafte Aus- und Weiterbildungen, welche einzeln oder in Kombination miteinander eingesetzt werden können, sind der Gegenstand der abhängigen Ansprüche.
Erfindungsgemäß wird diese Aufgabe durch einen Schütz mit einer elektronischen Spulenansteuerung für eine Magnetspule gelöst, wobei unter anderem das Konstanthalten der Anzugsleistung der Magnetspule durch eine Stromtaktung ausgebildet ist, und mit einer sicherheitsgerichteten Ausgangsbaugruppe einer speicherprogrammierbaren Steuerung für die Fehlerdiagnose des Schütz, wobei die sicherheitsgerichtete Ausgangsbaugruppe den Stromfluss, der in den Schütz fließt, ermittelt und bei Unterschreiten eines Grundwertes einen Fehler erkennt und abschaltet. Die Erfindung zeichnet sich dabei dadurch aus, dass im Schütz eine zuschaltbare Grundlast integriert ist.
Der Kern der Erfindung besteht darin, dass eine Grundlast im Schütz eingebracht wurde, um Fehlauslösungen zu vermeiden, wobei aber die Vorteile eines geringen Energieverbrauchs erhalten bleiben sollten. Diese Grundlast ist jedoch nur zu dem Zeitpunkt aktiv, wenn sie tatsächlich benötigt wird, also immer dann, wenn das Gerät sich entweder in der Hochlaufphase befindet und noch kein Strom durch die Magnetspule fließt oder während der Pausenzeiten gemäß der Taktvorgaben des Antriebs. Um dies zu erreichen, wird das Signal, welches dem Antrieb den Takt angibt, invertiert und auf einen Schalter aufgeprägt, der in Reihe mit der Grundlast liegt. Zusätzlich kann auch noch eine Zeitsteuerung integriert werden, die diese aktive Phase auf den Anzugsvorgang des Schütz beschränkt.

Die Vorteile dieses erfindungsgemäßen Schütz bestehen darin, dass der elektronisch gesteuerte Schütz ohne Zusatzaufwand an einem sicherheitsgerichteten speicherprogrammierbaren Steuerungsausgang betreibbar ist. Die erfindungsgemäße Lösung verzichtet zudem auf die Verwendung eines Zusatzwiderstandes, so dass es zu keiner zusätzlichen Wärmeentwicklung bzw. Verlustleistung kommt.

Die zuschaltbare Grundlast ist in der Hochlaufphase des Schütz, wenn noch kein Strom durch die Magnetspule fließt, zugeschaltet.

Die zuschaltbare Grundlast ist in den Pausenzeiten der Stromtaktung für die Magnetspule zugeschaltet.

Ein Schalter ist mit der zuschaltbaren Grundlast in Reihe geschaltet.

Auf den Schalter ist das Signal, welches der Spulenansteuerung den Takt vorgibt, invertiert aufgeprägt. Eine spezielle Ausgestaltung dieses erfindungsgemäßen Konzepts kann darin bestehen, dass im Schütz eine Zeitsteuerung integriert ist.
Eine vorteilhafte Ausgestaltung des erfindungsgemäßen Konzepts kann darin bestehen, dass die aktive Phase der Zeitsteuerung auf den Anzugsvorgang des Schütz beschränkt ist.
Der erfindungsgemäße Schütz weist eine elektronische Spulenansteuerung auf, die über einen Schalter mit einer Magnetspule elektrisch verbunden ist. Zwischen elektronischer Spulenansteuerung und Schalter ist eine Signalaufbereitung angeordnet, die in der Art eines Inverters arbeitet und das Signal, welches an die Magnetspule geht, invertiert wieder an eine Auswerte- und Steuereinheit abgibt. Die Auswerte- und Steuereinheit kann mit einer Zeitsteuerung in Form eines Timers elektrisch verbunden sein. Die aktive Phase der Zeitsteuerung kann auf den Anzugsvorgang des Schützes beschränkt sein. Die Auswerte- und Steuereinheit ist zudem mit einem Schalter elektrisch verbunden, welcher mit einer Grundlast in Reihe geschaltet ist. Durch den Schalter ist die Grundlast bei Bedarf, also in der Hochlaufphase des Schütz, wenn noch kein Strom durch die Magnetspule fließt, oder in den Pausenzeiten der Stromtaktung für die Magnetspule, zuschaltbar.

Weitere Ausführungen und Vorteile der Erfindung werden nachfolgend anhand eines Ausführungsbeispiels sowie anhand der Zeichnung erläutert.

Dabei zeigen:
Fig. 1 in einer schematischen Darstellung ein Schaltbild eines erfindungsgemäßen Schütz;
Fig. 2 in einer grafischen Darstellung die Taktung der Magnetspule und der zuschaltbaren Grundlast im Anzugs- und Haltebetrieb.

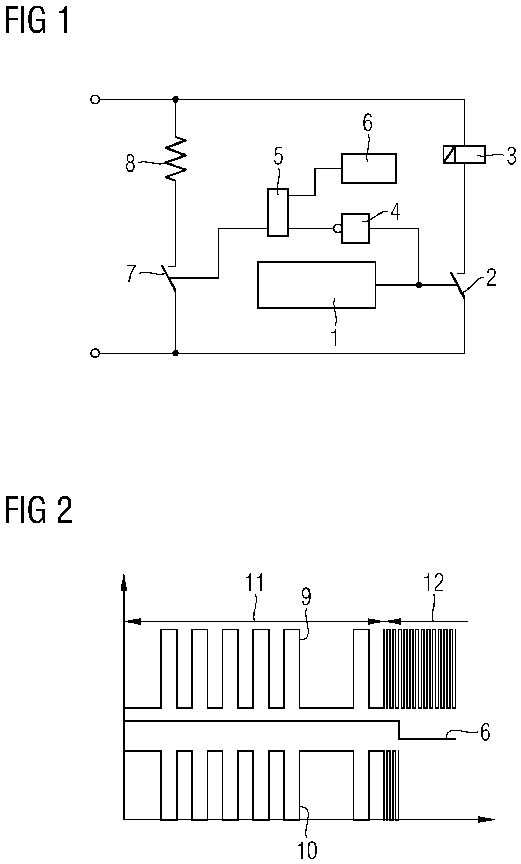

In Fig. 1 ist ein Schaltbild eines erfindungsgemäßen Schütz dargestellt. Der erfindungsgemäße Schütz weist eine elektronische Spulenansteuerung 1 auf, die über einen Schalter 2 mit einer Magnetspule 3 elektrisch verbunden ist. Zwischen der elektronischen Spulenansteuerung 1 und dem Schalter 2 ist eine Signalaufbereitung 4 angeordnet, die in der Art eines Inverters arbeitet und das Signal, welches an die Magnetspule 3 geht, invertiert wieder an eine Auswerte- und Steuereinheit 5 herausgibt. Die Auswerte- und Steuereinheit 5 kann mit einer Zeitsteuerung 6 in Form eines Timers elektrisch verbunden sein. Die Auswerte- und Steuereinheit 5 wertet die beiden Eingangssignale der Zeitsteuerung 6 und das aufbereitete Signal aus der Magnetspule 3 aus und gibt ein entsprechendes Signal an einen Schalter 7, welcher mit einer Grundlast 8 in Reihe geschaltet ist. Durch die Zeitsteuerung 6 kann die aktive Phase auf den Anzugsvorgang des Schütz beschränkt werden. Durch den Schalter 7 ist die Grundlast 8 bei Bedarf, also in der Hochlaufphase des Schütz, wenn noch kein Strom durch die Magnetspule 3 fließt, oder in den Pausenzeiten der Stromtaktung für die Magnetspule 3, zuschaltbar.

Fig. 2 zeigt eine grafische Darstellung für die Stromtaktung 9 in der Magnetspule 3 sowie für die Stromtaktung 10 für die Grundlast 8 im Anzugsbetrieb 11 sowie im Haltebetrieb 12. Zwischen der Stromtaktung 9 für die Magnetspule 3 und der Stromtaktung 10 für die Grundlast 8 ist die Zeitsteuerung 6 dargestellt. Die aktive Phase der Zeitsteuerung 6 ist lediglich auf den Anzugsbetrieb 11 ausgedehnt. Aus der grafischen Darstellung ist zu entnehmen, dass die Grundlast 8 nur dann aktiv ist, wenn sie tatsächlich benötigt wird, also immer dann, wenn der Schütz sich entweder in der Hochlaufphase befindet, in der noch kein Strom durch die Magnetspule 3 fließt oder während der Pausenzeiten in der Stromtaktung der Magnetspule 3 im Anzugsbetrieb 11.

Der erfindungsgemäße Schütz zeichnet sich dadurch aus, dass er ohne Zusatzaufwand am sicherheitsgerichteten SPS-Ausgang betreibbar ist. Die erfindungsgemäße Lösung verzichtet zudem auf die Verwendung eines Zusatzwiderstandes, so dass es zu keiner zusätzlichen Wärmeentwicklung bzw. Verlustleistung kommt.

### Bezugszeichenliste

- 1: elektronische Spulenansteuerung
- 2: Schalter
- 3: Magnetspule
- 4: Signalaufbereitung
- 5: Auswerte- und Steuereinheit
- 6: Zeitsteuerung
- 7: Schalter
- 8: Grundlast
- 9: Stromtaktung
- 10: Stromtaktung
- 11: Auszugsbetrieb
- 12: Haltebetrieb

## Patentansprüche

1. Schütz mit einer elektronischen Spulenansteuerung (1) für eine Magnetspule (3), wobei das Konstanthalten der Anzugsleistung der Magnetspule (3) durch eine Stromtaktung (9) ausgebildet ist, und mit einer sicherheitsgerichteten Ausgangsbaugruppe einer speicherprogrammierbaren Steuerung für die Fehlerdiagnose des Schütz, wobei die sicherheitsgerichtete Ausgangsbaugruppe den Stromfluss, der in den Schütz fließt, ermittelt und bei Unterschreiten eines Grenzwertes einen Fehler erkennt und abschaltet, **dadurch gekennzeichnet, dass** im Schütz eine zuschaltbare Grundlast (8) integriert ist,
- wobei die zuschaltbare Grundlast (8) in der Hochlaufphase des Schütz, wenn noch kein Strom durch die Magnetspule (3) fließt, zugeschaltet ist,
- wobei die zuschaltbare Grundlast (8) in den Pausenzeiten der Stromtaktung (9) für die Magnetspule (3) zugeschaltet ist,
- wobei ein Schalter (7) mit der zuschaltbaren Grundlast (8) in Reihe geschaltet ist und
- wobei auf den Schalter (7) das Signal, welches der Spulenansteuerung (1) den Takt vorgibt, invertiert aufgeprägt ist.

2. Schütz nach Anspruch 1, **dadurch gekennzeichnet, dass** im Schütz eine Zeitsteuerung (6) integriert ist.

3. Schütz nach Anspruch 2, **dadurch gekennzeichnet, dass** die aktive Phase der Zeitsteuerung (6) auf den Anzugsvorgang des Schütz beschränkt ist.

## Claims

1. Contactor having electronic coil control (1) for a magnet coil (3), the operation of keeping the pull-in power of the magnet coil (3) constant being formed by current clocking (9), and having a safety-related output assembly of a programmable logic controller for the fault diagnosis of the contactor, the safety-related output assembly determining the flow of current which flows into the contactor and detecting a fault if a limit value is undershot and switching off, **characterized in that** a connectable base load (8) is integrated in the contactor,
- wherein the connectable base load (8) is connected in the start-up phase of the contactor if current is not yet flowing through the magnet coil (3),
- wherein the connectable base load (8) is connected in the pause times of the current clocking (9) for the magnet coil (3),
- wherein a switch (7) is connected in series with the connectable base load (8), and
- wherein the signal which specifies the clock for the coil control (1) is impressed on the switch (7) in an inverted manner.

2. Contactor according to Claim 1, **characterized in that** time control (6) is integrated in the contactor.

3. Contactor according to Claim 2, **characterized in that** the active phase of the time control (6) is restricted to the pull-in process of the contactor.

## Revendications

1. Protection avec commande électronique de bobine (1) pour une bobine magnétique (3), la stabilisation de la puissance d'attraction de la bobine magnétique (3) étant effectuée par une synchronisation du courant (9), et avec le bloc de sortie orienté sécurité d'une commande à mémoire programmable pour le diagnostic des erreurs de la protection, le bloc de sortie orienté sécurité détectant le flux de courant, s'écoulant dans la protection, et en cas de dépassement négatif d'une valeur de seuil, reconnaissant une erreur et s'éteignant, **caractérisée en ce que** dans la protection est intégrée une charge de base (8) commutable,
- la charge de base (8) commutable, étant commutée dans la phase de haut régime de la protection, quand aucun courant ne s'écoule à travers la bobine magnétique (3),
- la charge de base (8) commutable étant commutée dans les durées de pause de la synchronisation du courant (9) pour la bobine magnétique (3),
- un commutateur (7) étant connecté en série avec la charge de base (8) commutable, et
- sur le commutateur (7), le signal, qui donne la cadence à la commande de bobine (1), étant inversé.

2. Protection selon la revendication 1, **caractérisée en ce qu'**une commande temporisée (6) est intégrée à la protection.

3. Protection selon la revendication 2, **caractérisée en ce que** la phase active de la temporisation (6) est limitée au processus d'attraction de la protection.
